## Europäisches Patentamt

## European Patent Office

## Office européen des brevets

(19)

(11) Veröffentlichungsnummer: **0 112 486**
**A2**

(12) **EUROPÄISCHE PATENTANMELDUNG**

(21) Anmeldenummer: **83111506.8**

(22) Anmeldetag: **17.11.83**

(51) Int. Cl.³: **G 03 D 15/02, G 03 F 7/26**

(30) Priorität: **26.11.82 DE 3243873**

(43) Veröffentlichungstag der Anmeldung: **04.07.84**
**Patentblatt 84/27**

(84) Benannte Vertragsstaaten: **AT BE CH DE FR GB IT LI NL SE**

(71) Anmelder: **HOECHST AKTIENGESELLSCHAFT, Postfach 80 03 20, D-6230 Frankfurt am Main 80 (DE)**

(72) Erfinder: **Idstein, Hermann, Johannisberger Strasse 55, D-6227 Oestrich-Winkel 2 (DE)**

(54) **Transport- und Abquetscheinrichtung.**

(57) Die Erfindung betrifft eine Transport- und Abquetscheinrichtung (1) für Druckmaterialien, wie Druckplatten, lichtempfindlich beschichtete Papiere, Folien od.dgl. in einem Verarbeitungsgerät. Die Einrichtung umfaßt eine Andruckwalze (20) und eine angetriebene Transportwalze (21), an welche die Andruckwalze (20) mit Hilfe von Andruckeinrichtungen (22, 22') beigestellt wird, um einen sicheren Transport einer Druckplatte und das Abquetschen von Entwicklerflüssigkeit od.dgl. Chemikalien von der Druckplattenoberfläche in dem Verarbeitungsgerät zu gewährleisten. Sowohl die Andruck- als auch die Transportwalze ist jeweils von einer Steckachse durchsetzt, die aus einem Innenrohr und in dieses beiderseits eingesetzten Lagerzapfen besteht. Die Steckachsen sind derart gelagert, daß ihre Durchbiegung bei Belastung ohne Einfluß auf die Durchbiegung der Walzrohre der Walzen (20, 21) bleibt, wodurch die Gesamtdurchbiegung des Walzenrohrs (5) gering ist. Die Transportwalze (21) durchsetzt Seitenschilde (24, 24') mit ihren Lagerzapfen, die in innerhalb von Lagerschalen (26, 26') angeordneten Lagern gelagert sind. Von den Lagerzapfen der Andruckwalze (20) abgesetzte Zapfenenden (27, 27') sind in Führungsleisten (25, 25') gelagert, die auf der Innenseite von Seitenschilden von Befestigungsschrauben (30, 30') durchsetzt sind.

Transport- und Abquetscheinrichtung

Die Erfindung betrifft eine Transport- und Abquetscheinrichtung in einem Verarbeitungsgerät für Druckmaterialien, mit aus Walzenrohren gebildeten Walzen und einer das Innere der einzelnen Walze durchsetzenden Achse, auf deren Enden in Richtung der jeweils gegenüberliegenden Walze Kräfte wirken, wobei die eine Walze eine Andruckwalze und die andere Walze eine angetriebene Transportwalze ist.

Aus der DE-OS 31 08 095 ist eine derartige Walzenanordnung einer Fixiereinrichtung in einem Fotokopiergerät bekannt, wobei zumindest eine der Walzen als Rohr mit konkaver Mantelfläche ausgebildet ist. Im Inneren und in der Mitte einer solchen Walze ist ein Stützlager vorgesehen, das mit Hilfe einer Achse oder Welle die Walze belastet, so daß sie sich längs einer Linie an die Gegenwalze anlegt. Hierdurch wird erreicht, daß die Druckverteilung über die gesamte Länge der Walze konstant ist und die Walze einen relativ kleinen Walzendurchmesser aufweisen kann, wodurch Bauhöhe gespart wird. Die Enden der Walze oder der Walzen sind gegen seitliches Auswandern mit Rollen abgestützt. In den Enden der Walzen sind Gleitbuchsen oder ausgebuchste Kugellager in einem Langloch vorgesehen, durch welche die Achse mit entsprechend abgeflachten Teilen greift. Es können beide Walzen als Hohlwalzen ausgebildet sein, jedoch genügt eine als Hohlwalze ausgebildete Walze, der eine weitere zylindrisch geformte Walze gegenübersteht.

HOECHST AKTIENGESELLSCHAFT
KALLE Niederlassung der Hoechst AG

- 2 -

In dieser Offenlegungsschrift ist auch ein Stand der Technik beschrieben, der zylinderförmige Walzen für eine Fixiervorrichtung vorsieht, welche sich längs einer Mantellinie berühren. Soll der Toner auf einer Kopie fixiert werden, welche in Längsrichtung zwischen den Walzen hindurchläuft, müssen beispielsweise die Walzen mit 630 kp belastet werden. Diese Kraft darf die Walzen nur geringfügig durchbiegen, weswegen massive und dicke Walzen verwendet werden. Der Nachteil derartiger Walzenanordnungen für die Kaltfixierung von Tonerbildern besteht darin, daß auf die Enden der Walzen die notwendigen Kräfte ausgeübt werden müssen, wodurch sich die Druckverteilung zur Mitte der Walzen hin abschwächt, d.h. daß der Druck sich nicht gleichmäßig über die Gesamtlänge der Walzen verteilt.

Um diesem Nachteil abzuhelfen, ist es auch bekannt, zwei zylindrische Walzen unter einem kleinen Winkel zueinander anzuordnen, so daß sich die Walzen zunächst nur in der Mitte der Walzen in einem Punkt berühren. Wird auf die Enden der Walzen die notwendige Kraft ausgeübt, so verformen sich die Walzen derart, daß sie sich über ihre ganze Länge berühren. Die Druckverteilung ist dabei gleichmäßiger als bei der zuvor beschriebenen Ausbildung, jedoch werden auf das Kopierblatt Scherkräfte ausgeübt, die zu einer bleibenden Verformung des Kopierblatts führen können. Es ist auch bereits vorgeschlagen worden, die Walzen tonnenförmig, d.h. konvex auszubilden, so daß ihr Durchmesser in der Mitte etwas größer als an den Enden ist. Beim Aufein-

HOECHST AKTIENGESELLSCHAFT
KALLE Niederlassung der Hoechst AG

- 3 -

anderpressen derartiger Walzen kann eine gleichmäßige
Druckverteilung über die Walzenlänge erreicht werden,
jedoch wird das Papierblatt in der Mitte der Walze
schneller als an den Rändern transportiert, was zur
Folge hat, daß das Blatt von den Seiten her zur Mitte
der Walzen gedrückt wird und sich dort eine unerwünschte Quetschfalte bilden kann.

In Verarbeitungsgeräten für Druckplatten, fotoempfindlich beschichteten Papieren, Folien oder dgl. Materialien, die nach einer bildmäßigen Belichtung entwickelt werden, sind Transport- und Abquetscheinrichtungen aus zwei gegeneinander andrückbaren Walzen vorgesehen, die den Weitertransport der Druckplatten und
das gleichzeitige Abquetschen der überschüssigen Entwicklerflüssigkeit, sonstiger Chemikalien für die Entwicklung sowie der Reinigungsflüssigkeit von den beiden Seiten der Druckplatten bewerkstelligen. Werden
für derartige Transport- und Abquetscheinrichtungen
Hohlwalzen mit durchgehenden oder mit an die Stirnflächen der Hohlwalzen anschließenden Achsen verwendet, die mit den Hohlwalzen starr verbunden sind, ergibt sich eine Gesamtdurchbiegung des Walzenpaares,
die in der Walzenmitte einen Spalt größer als 1 mm
entstehen läßt, wodurch der Abquetschwirkungsgrad des
Walzenpaars niedrig ist und somit der Austrag an Entwicklerflüssigkeit bzw. sonstigen Chemikalien durch
die Druckplatten groß ist.

Aufgabe der Erfindung ist es, eine Transport- und Abquetscheinrichtung derart zu verbessern, daß die gesamte Durchbiegung in der Walzenmitte des Walzenpaares verkleinert und somit der Austrag an Entwickler-Chemikalien durch die Druckmaterialien verringert wird und daß der sichere Transport der Druckmaterialien, ohne diese zu verformen oder zu beschädigen, gewährleistet ist.

Diese Aufgabe wird erfindungsgemäß dadurch gelöst, daß die Achsen der beiden Walzen Steckachsen sind, von denen die Steckachse der Andruckwalze mittels Kugellager frei biegbar in Lagerbuchsen des Walzenrohrs der Andruckwalze gelagert ist und die Steckachse der Transportwalze mittels O-Ringen axial-federnd in Lagerbuchsen des Walzenrohrs der Transportwalze zentriert ist und daß jede der Steckachsen aus einem Innenrohr mit beiderseits eingesetzten Lagerzapfen besteht.

In Ausgestaltung der Erfindung sind auf die Steckachse der Andruckwalze beidseitig die Kugellager, Distanzscheiben und Dichtungen aufgeschoben und durch weitere Distanzscheiben und Sicherungsringe gegen axiales Verschieben gesichert. Die Lagerung der Antriebswalze erfolgt in der Weise, daß die Lagerzapfen der Steckachse der Antriebswalze abgesetzte Zapfenenden aufweisen, daß Führungsleisten auf der Innenseite der Seitenschilde des Verarbeitungsgeräts von Befestigungsschrauben von den Außenseiten her nach innen durchsetzt und die Zapfenenden in den Führungsleisten gelagert sind.

HOECHST AKTIENGESELLSCHAFT
KALLE Niederlassung der Hoechst AG

- 5 -

In Weiterbildung der Erfindung sind auf den Innenseiten der Seitenschilde oberhalb der Steckachse der
Andruckwalze Andruckeinrichtungen angeordnet, die im
Betrieb gegen die Zapfenenden der Steckachse der Andruckwalze anliegen und diese gegen die angetriebene
Transportwalze beistellen. Die Innenringe der Kugellager weisen bevorzugt ein Axial-Spiel auf, das eine
Schrägstellung der Kuggellager und demzufolge eine
Durchbiegung des Innenrohrs der Andruckwalze bei Belastung zuläßt.

Die weitere Ausgestaltung der Erfindung ergibt sich
aus den Merkmalen der Patentansprüche 6 bis 10.

Mit der Erfindung wird der Vorteil erzielt, daß im
Vergleich zu bekannten Transport- und Abquetschwalzenpaaren herkömmlicher Bauart mit gleichgroßen Abmessungen wie die erfindungsgemäßen Walzen die Durchbiegung
in der Walzenmitte um mehr als 40 % verringert und die
Austragung von Chemikalien durch die Druckmaterialien
weitgehend verhindert wird.

Die Erfindung wird im folgenden anhand eines zeichnerisch dargestellten Ausführungsbeispiels näher
erläutert.

Es zeigen:

Fig. 1    eine Ansicht einer Transport- und Abquetscheinrichtung im belasteten Zustand der Andruck- und Transportwalze nach der Erfindung,

HOECHST   AKTIENGESELLSCHAFT
KALLE   Niederlassung der Hoechst AG

- 6 -

Fig. 2     die Antragwalze der Einrichtung nach Fig. 1
           im Schnitt,

Fig. 3     die Transportwalze der Einrichtung nach

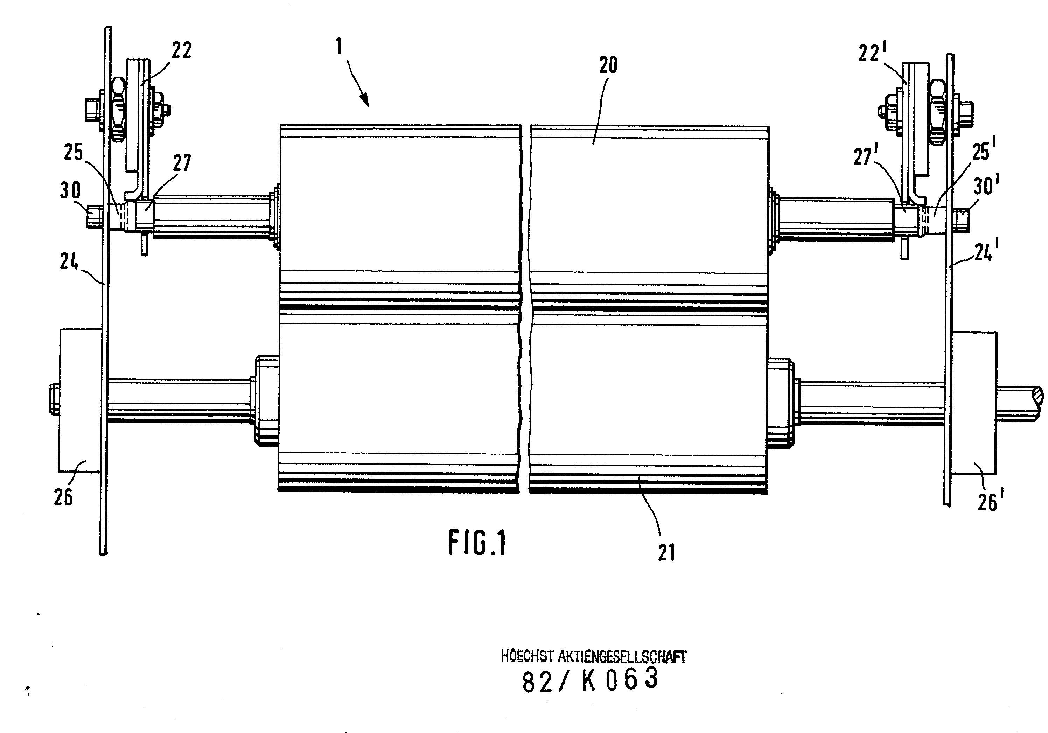

           Fig. 1 im Schnitt,

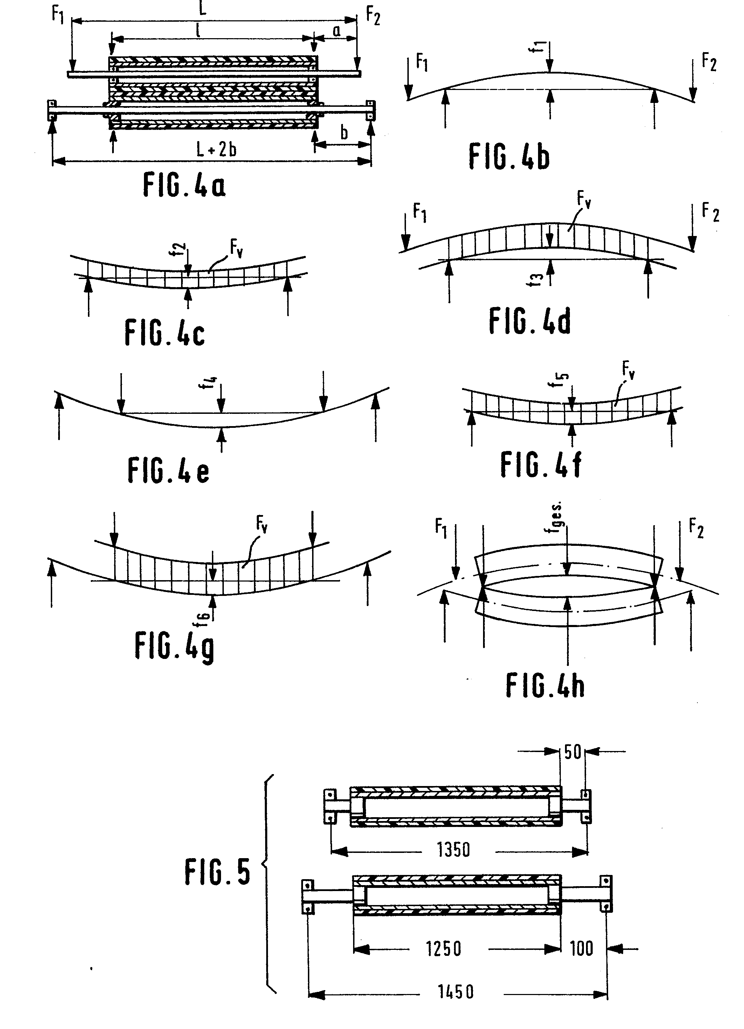

Fig. 4 (a) bis (h)   schematische Darstellungen der
           Verläufe der Durchbiegung der belasteten Walzen der Transport- und Abquetscheinrichtung,
           und

Fig. 5     eine schematische Darstellung einer Transport- und Abquetscheinrichtung nach dem Stand
           der Technik.

Fig. 1 zeigt eine Transport- und Abquetscheinrichtung 1, die ein Walzenpaar, bestehend aus einer Transportwalze 21 und einer darüber angeordneten Andruckwalze 20, umfaßt. Die Andruckwalze 20 ist mit ihren
Zapfenenden 27,27' in Führungsleisten 25,25' gelagert,
die auf der Innenseite von Seitenschilden 24,24' von
Befestigungsschrauben 30,30' von außen her durchsetzt
sind. Die angetriebene Transportwalze 21 durchsetzt
die Seitenschilde 24,24' mit ihren Lagerzapfen, die
von im Inneren von Lagerschalen 26,26' vorhandenen,
nicht dargestellten Lagern aufgenommen werden. Die
Lagerschalen 26,26' sind an den Außenseiten der Seitenschilde 24,24' angeordnet und befestigt.

Oberhalb der Achse der Andruckwalze 20 sind auf den
Innenseiten der Seitenschilde 24,24' Andruckeinrichtungen 22,22' befestigt, die im Betrieb gegen die Zapfenenden 27,27' der Andruckwalze 20 anliegen und diese gegen die angetriebene Transportwalze 21 unter Druck beistellen. Mit der Beistellung der Andruckwalze 20 gegen die untere angetriebene Transportwalze 21 über die Andruckeinrichtungen 22,22' wird ein sicherer Transport der Druckmaterialien, wie beispielsweise Druckplatten, oder empfindlichen beschichteten Papieren, Folien oder dgl. gewährleistet, wobei gleichzeitig durch das beiderseitige Abquetschen der Druckmaterialien eine Austragung von Entwickler-Chemikalien, Reinigungsflüssigkeiten oder Gummierungen weitgehend verhindert werden kann. Die Größe des Betrags der Gesamtdurchbiegung des Walzenpaars der Transport- und Abquetscheinrichtung 1 ist maßgebend für die Menge der ausgetragenen Chemikalien innerhalb eines Verarbeitungsgerätes, in dem die Transport- und Abquetscheinrichtung 1 eingesetzt ist. Wenn die Gesamtdurchbiegung des Walzenpaars klein gehalten wird, so ist auch dementsprechend der Austrag bzw. die Verschleppung an Chemikalien innerhalb des Verarbeitungsgeräts sehr gering.

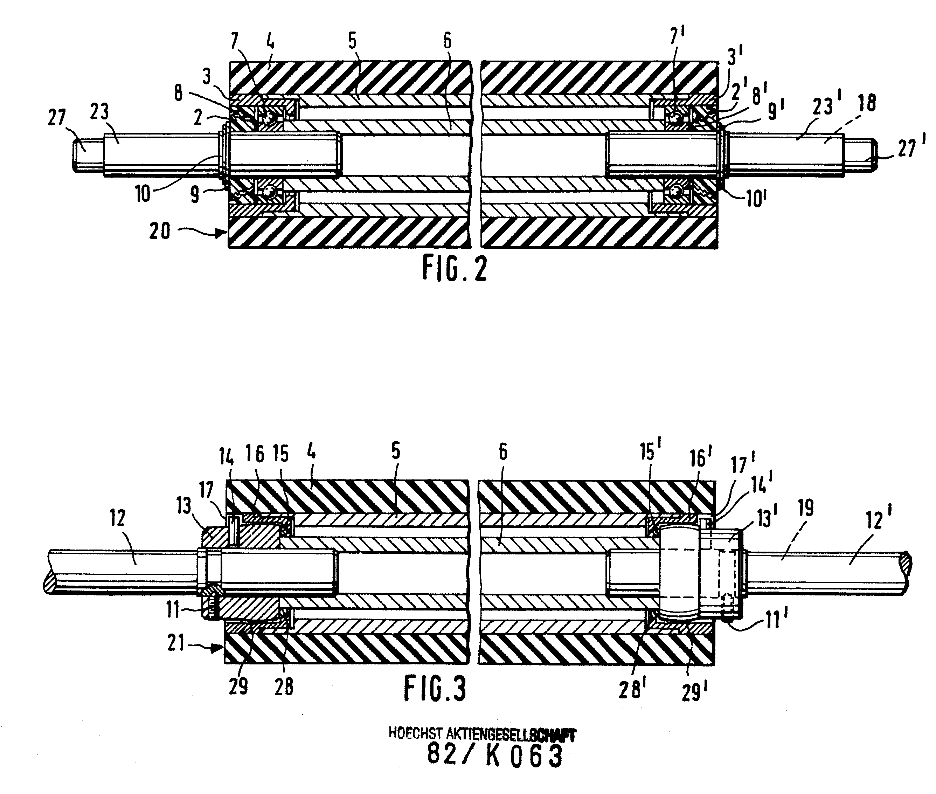

Wie aus den Fig. 2 und 3 ersichtlich ist, umfassen die Andruckwalze 20 sowie die Transportwalze 21 Walzenrohre 5, die mit einer Walzengummierung 4 an der Außenseite versehen sind, beispielsweise einer Perbunangummischicht. Die Andruckwalze 20, wie Fig. 2 zeigt, ist von einer Steckachse 18 durchsetzt, die sich aus einem Innenrohr 6 mit beiderseits eingesetzten Lagerzapfen

H O E C H S T   A K T I E N G E S E L L S C H A F T
KALLE  Niederlassung der Hoechst AG

- 8 -

23,23' zusammensetzt. Die Lagerzapfen sind bevorzugt aus korrosionsbeständigen Werkstoffen gefertigt und gehen in die abgesetzten Zapfenenden 27,27' über, deren Durchmesser kleiner als die Durchmesser der Lagerzapfen sind. Auf den Lagerzapfen 23,23' sind beidseitig Kugellager 7,7', Distanzscheiben 8,8' und Dichtungen 2,2' aufgeschoben und mittels Distanzscheiben 9,9' und Sicherungsringen 10,10' gegen axiales Verschieben gesichert.

An den Stirnseiten des Walzenrohrs 5 sind Lagerbuchsen 3,3' eingesetzt, welche die Kugellager 7,7' aufnehmen. Die Innenringe der Kugellager 7,7' besitzen ein Axial-Spiel, das eine Schrägstellung der Kugellager 7,7' und demzufolge eine Durchbiegung des Innenrohrs 6 der Andruckwalze 20 bei Belastung zuläßt. Durch diese Konstruktion ist die Steckachse 18 über die Kugellager 7,7' frei biegbar, so daß die Biegung der Steckachse 18 auf das Walzenrohr 5 keinen Einfluß hat.

Die Walzengummierung 4 ist im allgemeinen auf die Außenseite des Walzenrohrs 5 aufvulkanisiert, kann jedoch auch nur aufgeschoben sein. Für das Material der Lagerbuchsen 3,3' wird gleichfalls bevorzugt ein korrosionsbeständiger Werkstoff verwendet.

Fig. 3 zeigt einen Schnitt durch die Transportwalze 21, die ähnlich wie die Andruckwalze 20 aufgebaut ist. Träger der angetriebenen Transportwalze 21 ist eine Steckachse 19, die aus einem Innenrohr 6 und beider-

HOECHST AKTIENGESELLSCHAFT
KALLE Niederlassung der Hoechst AG

- 9 -

seits eingesetzten Antriebs- und Lagerzapfen 12,12'
besteht, die aus korrosionsbeständigem Werkstoff gefertigt sind. Auf den Antriebs- und Lagerzapfen 12,12'
sitzen beidseitig verschiebbare Lager- und Mitnehmernaben 13,13' auf, die durch Gewindestifte 11,11' auf
den Antriebs- und Lagerzapfen 12,12' befestigt sind.

An den Stirnseiten und der Innenwand des Walzenrohrs 5
der Transportwalze 21 sind Lagerbuchsen 16,16' eingesetzt, die Innenschrägen 28,28' aufweisen, welche
Dichtflächen für O-Ringe 15,15' bilden. Durch die bei
der Montage über die Gewindestifte 11,11' erzielte
axiale Vorspannung der Dichtflächen der Lagerbuchsen
16,16' und der Dichtflächen der Lager- und Mitnehmernaben 13,13' wird über die beiden O-Ringe 15,15' das
Eindringen von Feuchtigkeit in den Innenraum der
Transportwalze 21 verhindert. Gleichzeitig bilden die
O-Ringe 15,15' eine axial-federnde Zentrierung des
Walzenrohres 5.

Die an den Innenseiten der Lagerbuchsen 16,16' anliegenden Flächen 29,29' der Lagernaben 13,13' sind ballig ausgebildet, um eine gleichförmige Durchbiegung
des Innenrohrs 6 bei Belastung der Transportwalze 21
zu ermöglichen, ohne die von der Zustellkraft und dem
Eigengewicht der Andruckwalze sowie dem Eigengewicht
der Transportwalze resultierenden Biegekräfte, die von
den Lagern in den Lagerschalen 26,26' und den Seitenschilden 24,24' aufgenommen werden, über die Lagerzapfen 12,12' auf das Walzenrohr 5 zu übertragen.

HOECHST AKTIENGESELLSCHAFT
KALLE Niederlassung der Hoechst AG

- 10 -

Das Walzenrohr 5 der Transportwalze 21 weist an den Stirnseiten Mitnahmenuten 17,17' auf, in die Mitnehmerstifte 14,14' eingreifen, welche mit den Lager- und Mitnehmernaben 13,13' verbunden sind und die das über die Lagerzapfen 12,12' und die Lager- und Mitnehmernaben 13,13' über die Gewindestifte 11,11' eingeleitete Drehmoment auf das Walzenrohr 5 übertragen.

Im Betrieb der Transport- und Abquetscheinrichtung 1 nach der Erfindung, wenn beispielsweise die Andruckwalze 20 der angetriebenen Transportwalze 21 über die Andruckeinrichtungen 22,22' beigestellt ist und eine Druckplatte durch den Spalt zwischen den beiden Walzen 20,21 hindurchtransportiert und die auf der Druckplatte befindlichen Flüssigkeiten abgequetscht werden, ergeben sich für die einzelne Walze die folgenden, in den Fig. 4 (a) bis (h) schematisch dargestellten Verläufe der durch die vorliegende Druckverteilung bedingten Durchbiegungen, die ohne Berücksichtigung der Verformung der Walzengummierung der beiden Walzen 20,21 für deren folgende Abmessungen gelten:

Andruckwalze 20

Innenrohr 6 der Steckachse 18:

$D = 25$ cm, $d = 15$ cm, $a = 5$ cm,

$l = 125$ cm, $L = 135$ cm,

$F = 20$ kp setzt sich zusammen aus $F_1 + F_2$.

0112486

HOECHST AKTIENGESELLSCHAFT
KALLE Niederlassung der Hoechst AG

- 11 -

Walzenrohr 5:

$$D = 42,4 \text{ cm}, \quad d = 33,2 \text{ cm},$$
$$l = 125 \text{ cm}, \quad L = 135 \text{ cm},$$
$$F_v = 10 \text{ kp gleichverteiltes Eigengewicht der Andruckwalze}$$

Die Durchbiegung

$$f_1 = \frac{F \, a \, l^2}{8 \, E \, J} = \frac{20 \cdot 5(125)^2 \text{ cm}}{2,1 \cdot 10^6 \frac{D^4 - d^4}{20}},$$

der Steckachse 18, wie in Fig. 4b gezeigt, ergibt sich zu 0,54 mm. Die Durchbiegung

$$f_2 = \frac{5 \cdot F_v \, l^3}{384 \cdot E \, J} = \frac{5 \cdot 10 \cdot (125)^3 \text{ cm}}{384 \cdot 2,1 \cdot 10^6 \frac{D^4 - d^4}{20}}$$

(Fig. 4c) des Walzenrohrs 5 infolge seines Eigengewichts beträgt 0,12 mm, während die Durchbiegung

$$f_3 = \frac{5 \, F \cdot L^3}{384 \, E \, J} = \frac{5 \cdot 20 \cdot (135)^3 \text{ cm}}{384 \cdot 2,1 \cdot 10^6 \frac{D^4 - d^4}{20}}$$

des Walzenrohrs 5 unter Druckbelastung 0,29 mm beträgt (vgl. Fig. 4d). Da die Durchbiegung der Steckachse 18 diejenige des Walzenrohrs 5, wie weiter oben ausgeführt wurde, nicht beeinflußt, beträgt die Gesamtdurchbiegung der Andruckwalze $- f_2 + f_3 = 0,17$ mm, wobei das Minuszeichen von $f_2$ den entgegengesetzten

HOECHST AKTIENGESELLSCHAFT
KALLE Niederlassung der Hoechst AG

- 12 -

Verlauf der Druckbelastung des Walzenrohrs 5 infolge seines Eigengewichts im Vergleich zu der Biegebeanspruchung durch die Last F wiedergibt, die sich aus Lasten $F_1$ und $F_2$ zusammensetzt, von denen jede 10 kp beträgt.

Transportwalze 21

Innenrohr 6 der Steckachse 19:

D = 25 cm, d = 15 cm, b = 10 cm,

l = 125 cm, L = 135 cm,

F = 40 kp setzt sich zusammen aus $F_1 + F_2$ = 20 kp und dem jeweiligen Eigengewicht von 10 kp der Andruck- und der Transportwalze

Walzenrohr 5:

D = 42,4 cm, D = 33,2 cm,

l = 125 cm , L = 135 cm,

$F_v$ = 10 kp gleichmäßig verteiltes Eigengewicht der Transportwalze 21

Die Durchbiegung $f_4 = \dfrac{F\, b\, l^2}{8\, E\, J} = \dfrac{40\,.\,10\,.(125)^2\ cm}{2,1\,.\,10^6\,.\,\dfrac{D^4 - d^4}{20}}$

der Steckachse 19 (Fig. 4e) beträgt 2,18 mm. Die Durchbiegung

$$f_5 = \dfrac{5\,.\,F_v\, l^3}{384\,.\,E\,J} = \dfrac{5\,.\,10\,(125)^3\ cm}{384\,.\,2,1\,.\,10^6\ \dfrac{D^4 - d^4}{20}}$$

H O E C H S T   A K T I E N G E S E L L S C H A F T
KALLE   Niederlassung der Hoechst AG

- 13 -

des Walzenrohrs 5 (Fig. 4f) durch dessen Eigengewicht ist o,12 mm, während die Durchbiegung

$$f_6 = \frac{5 \, F \, l^3 \; cm}{384 \cdot 2,1 \cdot 10^6 \; \dfrac{D^4 - d^4}{20}}$$

$$= \frac{5 \cdot 10 \cdot (125)^3 \; cm}{384 \cdot 2,1 \cdot 10^6 \; \dfrac{D^4 - d^4}{20}} \qquad \text{des Walzenrohrs 5}$$

unter Druckbelastung o,34 mm beträgt (Fig. 4g). Die
Gesamtdurchbiegung der Transportwalze 21 ist somit
$f_5 + f_6 = 0,46$ mm, da die Durchbiegung $f_4$ der Steckachse 19 dabei nicht zu berücksichtigen ist.

Aus den Einzeldurchbiegungen errechnet sich die Gesamtdurchbiegung der Transport- und Abquetscheinrichtung zu  $-f_2 + f_3 + f_5 + f_6 = 0,63$ mm.

Zum Vergleich werden die Durchbiegungen der Walzen
einer Transport- und Abquetscheinrichtung nach dem
Stand der Technik, wie sie in Fig. 5 schematisch dargestellt ist, im folgenden den bisherigen Berechnungen gegenübergestellt. Die Abmessungen der Walzen sind
die gleichen wie bei dem Erfindungsgegenstand und betragen für die

Andruckwalze:
Rohr:   D = 42,4 cm,   d = 33,2 cm,   a = 5 cm,
        l = 125 cm,
        F = 20 kp gleichmäßig über die Walzenlänge ver-
        teilte Last

Durchbiegung $f_1$ der Andruckwalze

$$= \frac{F \, a \, l^2}{8 \, E \, J} = \frac{10 \cdot 5 \cdot (125)^2 \text{ cm}}{2,1 \cdot 10^6 \cdot \dfrac{D^4 - d^4}{20}}$$

$f_1 = 0,09$ mm

Transportwalze

Rohr:  D = 42,4 cm,  d = 33,2 cm,  b = 10 cm

l = 125 cm

F = 40 kp = $F_1$ + $F_2$ + Eigengewicht der Andruckwalze + Eigengewicht der Transportwalze

Durchbiegung $f_4$ der Transportwalze

$$= \frac{F \, b \, l^2}{8 \, E \, J} = \frac{40 \cdot 10 \cdot (125)^2 \text{ cm}}{2,1 \cdot 10^6 \cdot \dfrac{D^4 - d^4}{20}}$$

$f_4 = 0,36$ mm

Die Durchbiegungen $f_1$ und $f_4$ treten an die Stelle der
zuvor berechneten Durchbiegungen für die Steckachsen
18 und 19 nach dem Erfindungsgegenstand. Da die Abmessungen der Walzen mit denjenigen nach dem Erfindungsgegenstand übereinstimmen, können die zuvor bestimmten
Werte der Durchbiegungen $f_2$, $f_3$, $f_5$, $f_6$ übernommen werden so daß für die Gesamtdurchbiegung

$f_1 + (-f_2) + f_3 + f_4 + f_5 + f_6 = 1,1$ mm

erhalten wird.

HOECHST AKTIENGESELLSCHAFT
KALLE Niederlassung der Hoechst AG

- 15 -

Der Vergleich der Gesamtdurchbiegungen der erfindungsgemäßen und einer herkömmlichen Transport- und Abquetscheinrichtung aus einem Walzenpaar ergibt

$$\frac{0{,}63 \text{ mm}}{1{,}1 \text{ mm}} \cdot 100 \ \% = 57{,}2 \ \%,$$

so daß die Gesamtdurchbiegung der erfindungsgemäßen
Andruck- und Transporteinrichtung weniger als 60 % von
gleichdimensionierten Walzen bekannter Bauart bei
einer Arbeitswalzenlänge von 1250 mm bei den dieser
Berechnung zugrunde gelegten Lagerabständen L für die
Andruckwalzen, und L + 2b für die Transportwalzen beträgt.

---

## Patentansprüche

1. Transport- und Abquetscheinrichtung in einem Verarbeitungsgerät für Druckmaterialien, mit aus Walzenrohren gebildeten Walzen und einer das Innere der einzelnen Walze durchsetzenden Achse, auf deren Enden in Richtung der jeweils gegenüberliegenden Walze Kräfte wirken, wobei die eine Walze eine Andruckwalze und die andere Walze eine angetriebene Transportwalze ist, dadurch gekennzeichnet, daß die Achsen der beiden Walzen (20,21) Steckachsen (18,19) sind, von denen die Steckachse (18) der Andruckwalze (20) mittels Kugellager (7,7') frei biegbar in Lagerbuchsen (3,3') des Walzenrohrs (5) der Andruckwalze (20) gelagert ist und die Steckachse (19) der Transportwalze (21) mittels O-Ringen (15,15') axial-federnd in Lagerbuchsen (16,16') des Walzenrohrs (5) der Transportwalze (21) zentriert ist und daß jede der Steckachsen (18,19) aus einem Innenrohr (6) mit beiderseits eingesetzten Lagerzapfen (23,23' bzw. 12,12') besteht.

2. Transport- und Abquetscheinrichtung nach Anspruch 1, dadurch gekennzeichnet, daß auf die Steckachse (18) der Andruckwalze (20) beidseitig die Kugellager (7,7'), Distanzscheiben (8,8') und Dichtungen (2,2') aufgeschoben und durch weitere Distanzscheiben (9,9') und Sicherungsringe (10,0') gegen axiales Verschieben gesichert sind.

0112486

HOECHST AKTIENGESELLSCHAFT
KALLE Niederlassung der Hoechst AG

- 17 -

3. Transport- und Abquetscheinrichtung nach Anspruch 2, dadurch gekennzeichnet, daß die Lagerzapfen (23,23') der Steckachse (18) der Antriebswalze (20) abgesetzte Zapfenenden (27,27') aufweisen, daß Führungsleisten (25,25') auf der Innenseite der Seitenschilde (24,24') des Verarbeitungsgeräts von Befestigungsschrauben (30,30') von den Außenseiten her nach innen durchsetzt und die Zapfenenden (27,27') in den Führungsleisten (25,25') gelagert sind.

4. Transport- und Abquetscheinrichtung nach Anspruch 3, dadurch gekennzeichnet, daß auf den Innenseiten der Seitenschilde (24,24') oberhalb der Steckachse (18) der Andruckwalze (20) Andruckeinrichtungen (22,22') angeordnet sind, die im Betrieb gegen die Zapfenenden (27,27') der Steckachse (18) der Andruckwalze (20) anliegen und diese gegen die angetriebene Transportwalze (21) beistellen.

5. Transport- und Abquetscheinrichtung nach Anspruch 1, dadurch gekennzeichnet, daß die Innenringe der Kugellager (7,7') ein Axial-Spiel aufweisen, das eine Schrägstellung der Kuggellager (7,7') und demzufolge eine Durchbiegung des Innenrohrs (6) der Andruckwalze (20) bei Belastung zuläßt.

6. Transport- und Abquetscheinrichtung nach Anspruch 1, dadurch gekennzeichnet, daß auf den Lagerzapfen (12,12') der Steckachse (19) der Transportwalze (21) beidseitig verschiebbare Lagernaben (13,13') aufsitzen, die durch Gewindestifte (11,11') auf den Lagerzapfen (12,12') festgesetzt sind.

7. Transport- und Abquetscheinrichtung nach Anspruch 6, dadurch gekennzeichnet, daß das Walzenrohr (5) der Transportwalze (21) an den Stirnseiten Mitnahmenuten (17,17') aufweist, in die Mitnahmestifte (14,14') eingreifen, die mit den Lagernaben (13,13') verbunden sind und die das über die Lagerzapfen (12,12') und die Lager- und Mitnehmernaben (13,13') eingeleitete Drehmoment über die Gewindestifte (11,11') auf das Walzenrohr (5) übertragen.

8. Transport- und Abquetscheinrichtung nach den Ansprüchen 3 und 7, dadurch gekennzeichnet, daß die Lagerzapfen (12,12') der Steckachse (19) der Transportwalze (21) die Seitenschilde (24,24') durchsetzen und in von Lagerschalen (26,26') umschlossenen Lagern gelagert sind.

9. Transport- und Abquetscheinrichtung nach Anspruch 1, dadurch gekennzeichnet, daß an den Stirnseiten und der Innenwand des Walzenrohrs (5) der Transportwalze (21) die Lagerbuchsen (16,16') aufsitzen, die Innenschrägen (28,28') aufweisen, die Dichtflächen für die 0-Ringe (15,15') bilden.

10. Transport- und Abquetscheinrichtung nach Anspruch 6, dadurch gekennzeichnet, daß die an den Innenseiten der Lagerbuchsen (16,16') anliegenden Flächen (29,29') der Lagernaben (13,13') ballig ausgebildet sind, um eine gleichförmige Durchbiegung des Innenrohrs (6) bei Belastung der Transportwalze (21) zu ermöglichen, ohne die von der Zustellkraft und dem Eigengewicht der Andruckwalze sowie dem Eigengewicht der Transportwalze resultierenden Biegekräfte, die von den Lagern in den Lagerschalen (26,26') und den Seitenschilden (24,24') aufgenommen werden, über die Lagerzapfen (12,12') auf das Walzenrohr (5) zu übertragen.

---

FIG.1

HOECHST AKTIENGESELLSCHAFT
82/ K 063

0112486

2/3

0112486

FIG.2

FIG.3

HOECHST AKTIENGESELLSCHAFT
82/ K 063

0112486

**FIG.4a**

**FIG.4b**

**FIG.4c**

**FIG.4d**

**FIG.4e**

**FIG.4f**

**FIG.4g**

**FIG.4h**

**FIG.5**

HOECHST AKTIENGESELLSCHAFT